# EUROPEAN PATENT APPLICATION

(11) **EP 1 564 827 A1**
(43) Date of publication of application: **17.08.2005**
(21) Application number: 04447034.2
(22) Date of filing: 10.02.2004
(51) Int. Cl.: H01L 51/30

(54) **Method for the manufacturing of multilayer mesogenic components**

(71) Applicant: Université Libre De Bruxelles, 1050 Brussels (BE)
(72) Inventor: Tant, Julien, 1080 Brussels (BE); Geerts, Yves, 1160 Brussels (BE); Kestemont, Gael, 1050 Brussels (BE)
(74) Representative: Van Malderen, Joelle

(57) **Abstract**

The present invention discloses a method for the manufacturing of an electronic component comprising the deposition of a multilayer structure of the successive mesogenic materials m₁, m₂.., mⱼ on a substrate (1) comprising the steps of:
- dissolving of a mesogenic material m₁,m₂..,mⱼ respectively in the solvents S₁, S₂.. Sⱼ ;
- depositing a first layer of said first mesogenic material m₁ dissolved in S₁, on a substrate (1);
- depositing a second layer of said second mesogenic material m₂ dissolved in S₂, on said first layer of mesogenic material m₁;
- depositing finally a supplementary layer of the mesogenic material mⱼ dissolved in Sⱼ, on a layer of mesogenic material m₍ⱼ₋₁₎;
wherein the mesogenic material m ₍ᵢ₋₁₎ is insoluble in the solvent Sᵢ of the following mesogenic material mᵢ in the manufacturing of the successive layers m₁, m₂.., mⱼ to avoid the washing of the layer m ₍ᵢ₋₁₎ by the solvent Sᵢ. (i = 2 to j).

## Description

### Field of the invention

The present invention is related to microelectronics and more particularly to a method for the manufacturing of multilayer mesogenic components and to the use of those components in electronic devices.

### State of the art

A liquid crystalline material, also called mesogenic material has been defined by Demus et al. in "Handbook of Liquid Crystals: Vol. 1 Fundamentals", (1998), Wiley-VCH. Considerable research efforts were performed over the last 20 years in the development of low-molecular-weight mesogenic materials with improved characteristics such as lower viscosity, increased temperature range, larger birefringence and dielectric anisotropy.

The high majority of the molecules showing a liquid crystalline behaviour have in common an anisotropy of shape and of rigidity. Rod-shaped molecules (i.e., one molecular axis is much longer than the two others) are called calamitic liquid crystals. Disk-like molecules (*i*.*e*., one molecular axis is much shorter than the two others) are called discotic liquid crystals.

Liquid crystals-based electronic devices such as liquid crystals displays (LCDs), organic light-emitting diodes (OLEDs), multimedia projectors, photovoltaic cells (PVCs), sensors, etc ... are of high industrial interest.

In the particular case of colour display, the liquid crystals are held between two transparent glass or plastic displays coated with polarising filters allowing only the pass of perpendicular polarised light. These plates are usually manufactured with transparent electrodes, typically made of indium tin oxide that makes it possible to apply an electric field across small areas of the film of liquid crystal. Inside the plates are colour filters, which form very small picture element regions (subpixels). A grouping of red, green and blue subpixels defines the colour that the pixel transmits.

Generally, multilayer components are required in electronic devices because active matrix LCDs have separate and independent transistors for each pixel of the display. The liquid crystalline character of the material is needed in order to increase the usually very low response time of the display.

PVCs have for purpose the conversion of light into electricity. Efficient PVCs require at least two mesogens of different electron (negative charges, e⁻) and holes (positive charges, h⁺) affinities. Light absorption leads to the formation of an exciton, which can only be efficiently split into a pair of free charges in the interface between a n-type (electron acceptor) and a p-type (hole acceptor) semiconductor. The charges can then migrate through the two layers to reach the electrodes, where they are collected. The addition of a third layer of mesogenic material permits to cover the entire solar light spectrum, increasing the devices light conversion efficiencies.

In liquid crystals based OLEDs, h⁺ are injected into the p-type semiconducting layer from a high work-function electrode (indium tin oxide, gold, ...) and e⁻ are transferred into the n-type semiconducting layer from a low work-function electrode (aluminium, silver, ...). The free charges have to be transferred into a third layer of electroluminescent mesogen, giving rise to charges recombination and light emission.

The manufacturing of multilayer mesogenic components, is usually difficult. The chemical vapour deposition technique (CVD) is currently used in bilayer component manufacturing of mesogenic materials, but the high vacuum level, necessary in this technique, is expensive and limits the application to small areas and to liquid crystals that are chemically stable under processing conditions.

Since no general rules can be applied to determine the solubility and insolubility characteristics of a material, they have to be determined experimentally.

Solution-based techniques for thin films manufacturing are spin coating, doctor blading, Langmuir-Blodgett, the zone casting process described by Tracz et al. (J. Am. Chem. Soc., (2003), *125*, 1682) and more specific methods such as the one described by Sakurada in US 2003/0159651A.

These methods were not applicable for the manufacturing of components with more than one layer of mesogenic materials. Indeed, if the first mesogenic layer is soluble in the solvent used for the deposition of the second mesogenic layer, the first layer is washed during the deposition process of the second layer.

The formation of a bilayer-like film by depositing a blend of two components of different solubility according to a spin coating method has been described by Schmidt-Mende et al. (Science, (2001), *293*, 1119 and Physica E, (2002), *14*, 263). This technique is only accessible to a few couples of materials and gives no real control to the interface position. Other problems are definition and regularity of the layers as far as a gradient of concentration over the entire film thickness is obtained.

Another method of bilayer devices manufacturing, consisting in the chemical cross-linking of the first layer before applying the second layer, has been described by Lupo *et al*. in EP 1028475 and US 6281430. Chemical cross-linking has for purpose to make the bottom layer material insoluble in the solvent of the second layer to be deposited. Unfortunately, this process has as consequence to disturb the liquid crystallinity of the coating material, to decrease the molecular order and so, to dramatically decrease the material conductivity and the dielectric anisotropy.

### Aims of the invention

The present invention aims to provide a method for the manufacturing of electronic components comprising mesogenic multilayer structures by solution deposition processes, using mesogenic materials that have solubility complementarities in adequate solvents.

In particular, the present invention provides a solution-based coating method wherein successive layers of mesogenic material are deposited on each other. The mesogenic material of the underlying layer being always insoluble in the solvent used for the depositing of the next layer in order to avoid the washing of the former layer.

### Summary of the invention

The present invention discloses a method for the manufacturing of an electronic component comprising the deposition of a multilayer structure of the successive mesogenic materials m₁, m₂.., mⱼ on a substrate (1) comprising the steps of:
- dissolving of a mesogenic material m₁,m₂..,mⱼ respectively in the solvents S₁, S₂.. Sⱼ ;
- depositing a first layer of said first mesogenic material m₁ dissolved in S₁, on a substrate (1);
- depositing a second layer of said second mesogenic material m₂ dissolved in S₂, on said first layer of mesogenic material m₁;
- depositing finally a supplementary layer of the mesogenic material mⱼ dissolved in Sⱼ, on a layer of mesogenic material m₍ⱼ₋₁₎;
wherein the mesogenic material m ₍ᵢ₋₁₎ is insoluble in the solvent Sᵢ of the following mesogenic material mᵢ in the manufacturing of the successive layers m₁, m₂.., mⱼ to avoid the washing of the layer m ₍ᵢ₋₁₎ by the solvent Sᵢ. (i = 2 to j)

In a first aspect of the present invention the mesogenic materials m₁, m₂.., mⱼ are selected from the group consisting of calamitic and/or discotic materials.

In a second aspect of the present invention said mesogenic materials m₁, m₂.., mⱼ are in a crystalline phase or in a mesophase and in particular in a plastic crystalline phase, liquid crystalline phase or glass phase at processing or electronic device working temperatures.

In a third aspect of the present invention the solvents S₁, S₂.. Sⱼ are selected from the group consisting of aromatic and aliphatic hydrocarbons, haloaromatic and haloaliphatic hydrocarbons, water, ether, ester, keton, alcohol, amine, amide, and acid based solvents.

In a general aspect of the present invention, the discotic n-type materials are selected from the group consisting of the structures I to XIV:

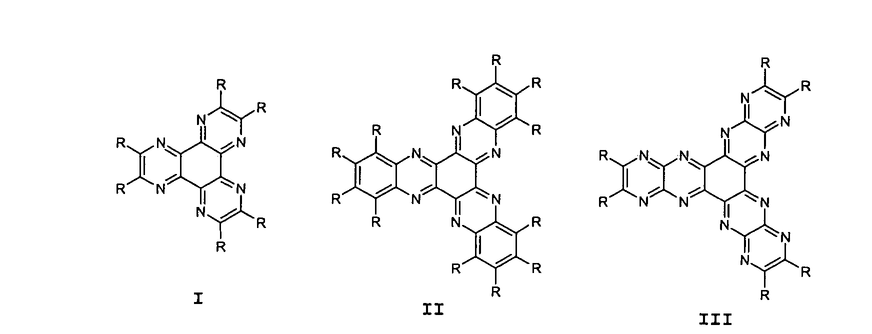

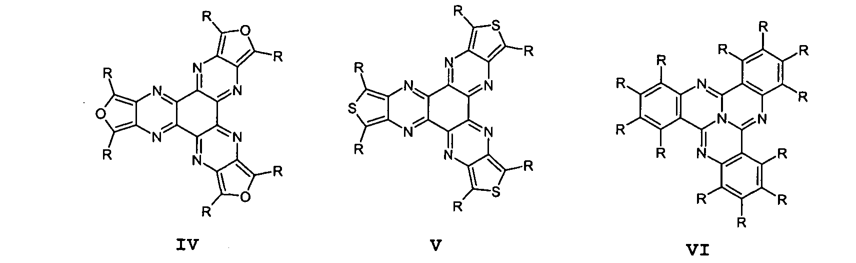

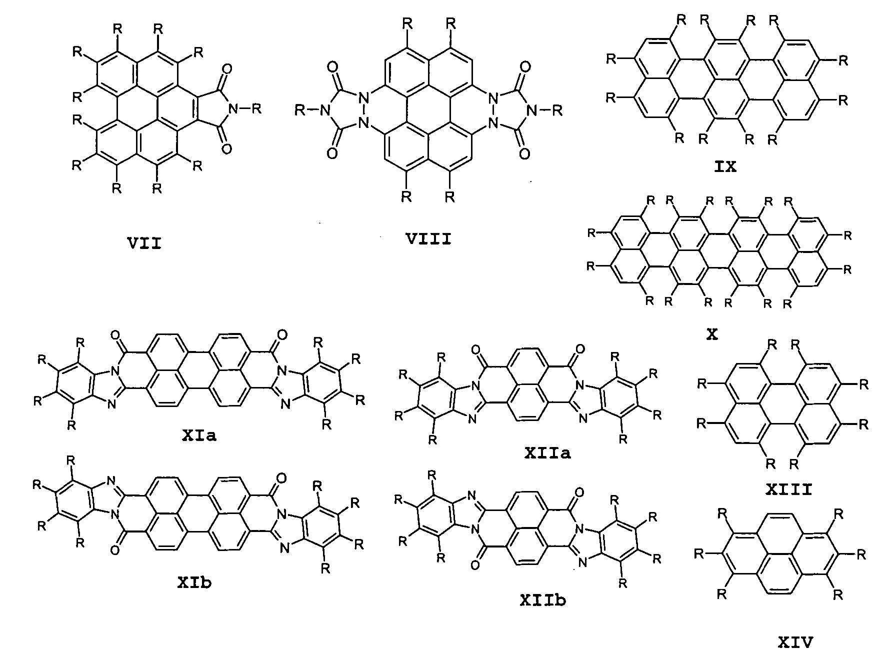

In another general aspect of the present invention the calamitic n-type materials are selected from the group consisting of the structures XV to XVII:

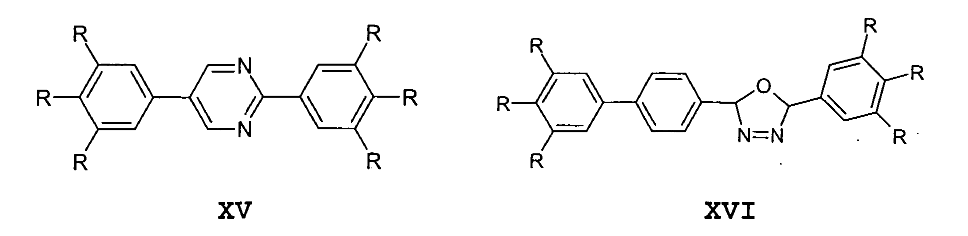

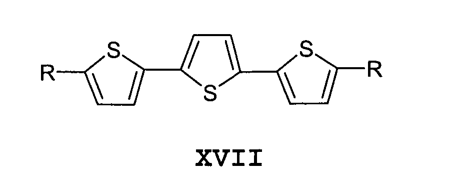

Advantageously, the discotic p-type materials are selected from the group consisting of the structures XVIII to XXII:

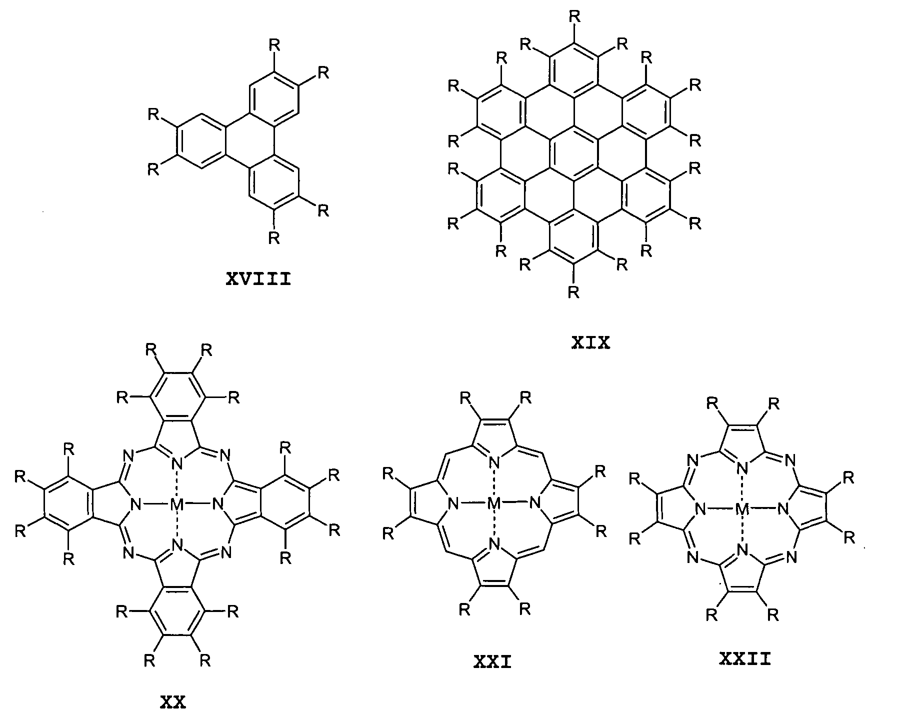

Furthermore the calamitic p-type materials are selected from the group consisting of the structures XXIII to XXXII:

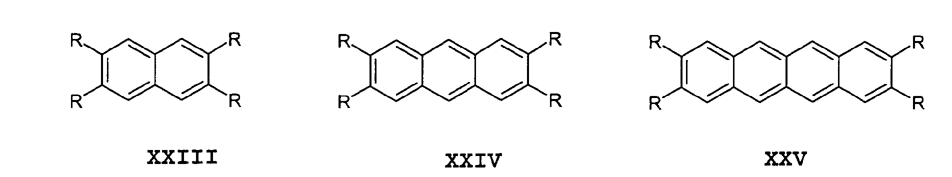

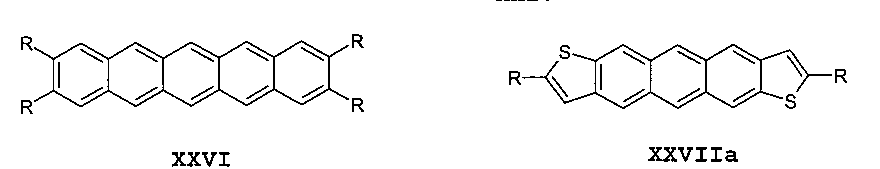

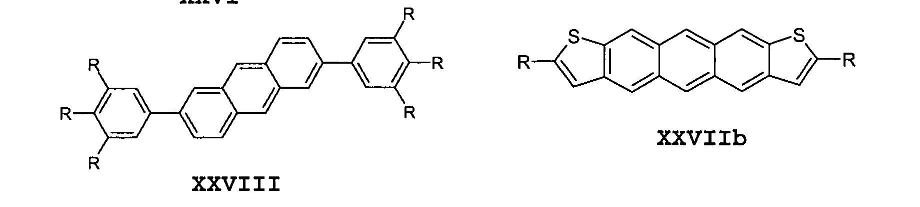

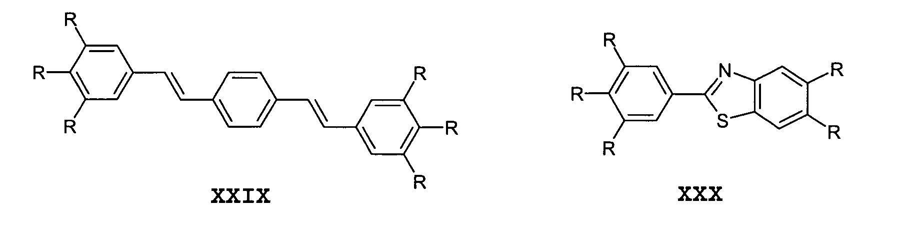

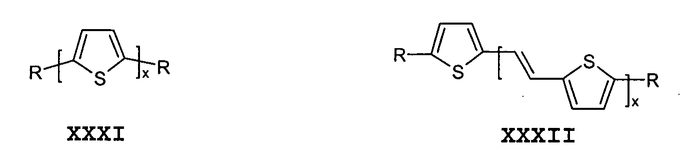

In a particular aspect of the present invention, high optical anisotropy liquid mesogenic materials are selected from the group consisting of the structures XXXIII to XXXVIII:

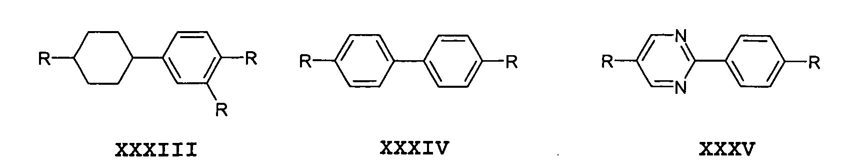

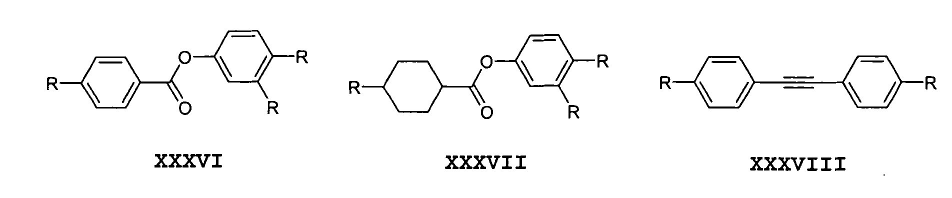

In another particular aspect of the present invention, a discotic material, soluble in high polarity solvents, is the structure XXXIX:

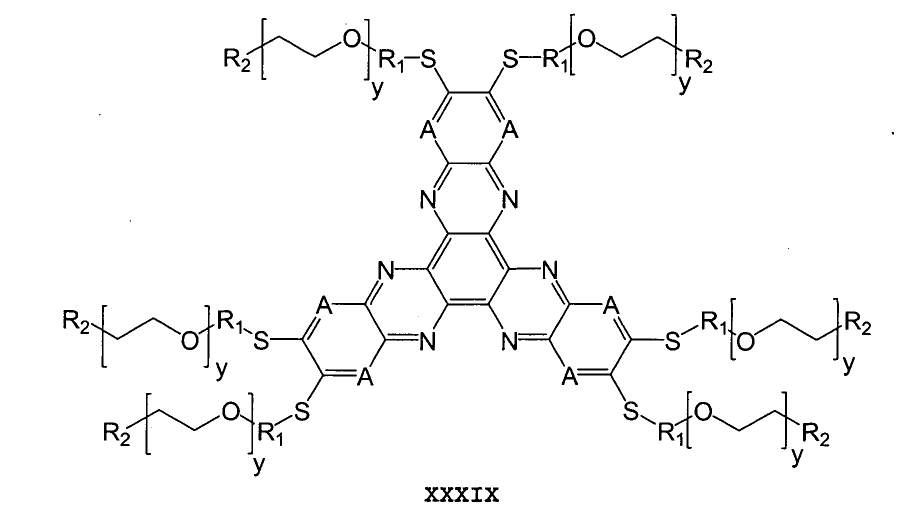

In an additional particular aspect of the present invention, a discotic material insoluble in high polarity solvents is the structure XL:

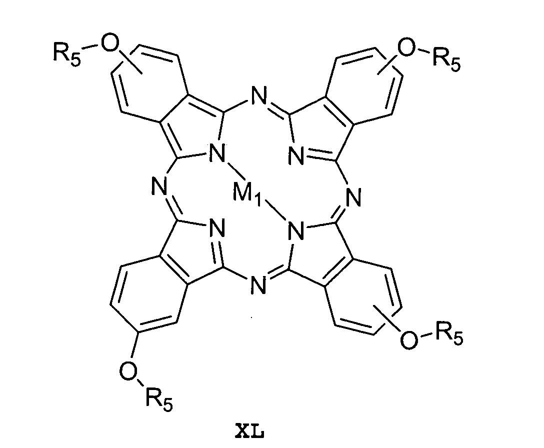

More precisely, the present invention discloses a method using the above mentioned molecules
- wherein "x" is the number of thiophene or vinylthiophene units and is between 2 and 6;
- wherein "M" can be one metal atom (Cu, Zn, Co, Pt, ...) or two atoms (Li₂, H₂);
- wherein "R" is an atom such as F, Cl, Br, I, H, ..., a functional group such as NH₂, NO₂, CN, SO₃H, COOH, ... or their salts, an aliphatic, an oligoether moieties, or a combination of them, preceded by a heteroatom such as S, O, N, ..., and/or a semi-flexible function such as ester, amide, ..., and/or or a rigid function such as alkene, alkyne, phenyl,...;
- wherein "A" is C-R₄ or N (nitrogen), and y is the number of ethyleneoxy units in each chain.
   R₂ is
      hydrogen (H) or deuterium (D)
      halogen (F, Cl, Br or I)
      nitro (NO₂)
      nitryl (CN)
   R₄ is
      ether (O-R₃)
      ester (O-CO- R₃ or CO-O- R₃)
      ketone (CO-R₃)
      alkyl (R₃)
   with R₁ and R₃ being an alkyl group, branched or not, of 1 to 10 carbon atoms. The number of ethyleneoxy units y is fixed between 1 and 6.
- wherein M₁ is a metal (zinc (Zn), copper (Cu), platinum (Pt), palladium (Pd)) or two protons (H₂), and R₅ is a branched aliphatic chain of 8 to 24 carbon atoms.

Additionally, the invention discloses a discotic material insoluble in high polarity solvents is: 2, 9 (10), 16 (17), 23 (24)-Tetra(2-decyltetradecyloxy)-phthalocyanine XL (M₁ is H₂ ; R₅ is 2-decyltetradecyl).

Furthermore, the invention discloses a discotic material soluble in high polarity solvents is: 2, 3, 8, 9, 14, 15-hexa{2-[2-(2-methoxy-ethoxy)-ethoxy]-5, 6, 11, 12, 17, 18-hexaaza-trinaphthylene XXXIX (A is C-R₄ ; R₄ is H ; R₁ is C₂H₄ ; R₂ is O-CH₃ ; y is 2)

In practice, the deposited successive layers have a thickness from 1 nm to 2 µm each and are deposited by spin coating, doctor blading, zone casting, or the Langmuir-Blodgett technique.

### Short description of the drawings

Fig.1 represents the schematic structure of one example of a bilayer device of the present invention.

Fig.2 represents the schematic structure of a bilayer field effect transistor of the present invention.

Fig.3 summarises some examples of n-type discotic liquid crystals that can be used in electronic devices according to the present invention. "R" can be composed, independently, by an atom (F, Cl, Br, I, H, ...), a functional group (NH₂, NO₂, CN, SO₃H, COOH, ...) or their salts, or an aliphatic, or oligoether moieties, or a combination of them, preceded by an heteroatom (S, O, N, ...), and/or a semi-flexible function (ester, amide, ...), and/or or a rigid function (alkene, alkyne, phenyl, ...).

Fig.4 summarises some examples of n-type calamitic liquid crystals that can be used in electronic devices according to the present invention. "x", the number of thiophene units, is taken between 2 and 6. "R" can be composed, independently, by an atom (F, Cl, Br, I, H, ...), a functional group (NH₂, NO₂, CN, SO₃H, COOH, ...) or their salts, or an aliphatic, or oligoether moieties, or a combination of them, preceded by an heteroatom (S, O, N, ...), and/or a semi-flexible function (ester, amide, ...), and/or or a rigid function (alkene, alkyne, phenyl, ...).

Fig.5 summarises some examples of p-type discotic liquid crystals that can be used in electronic devices according to the present invention. "M" can be one metal atom (Cu, Zn, Co, Pt, ...) or two atoms (Li₂, H₂). "R" can be composed, independently, by an atom (F, Cl, Br, I, H, ...), a functional group (NH₂, NO₂, CN, SO₃H, COOH, ...) or their salts, or an aliphatic, or oligoether moieties, or a combination of them, preceded by an heteroatom (S, O, N, ...), and/or a semi-flexible function (ester, amide, ...), and/or or a rigid function (alkene, alkyne, phenyl, ...).

Fig.6 summarises some examples of p-type calamitic liquid crystals that can be used in electronic devices according to the present invention. "R" can be composed, independently, by an atom (F, Cl, Br, I, H, ...), a functional group (NH₂, NO₂, CN, SO₃H, COOH, ...) or their salts, or an aliphatic, or oligoether moieties, or a combination of them, preceded by an heteroatom (S, O, N, ...), and/or a semi-flexible function (ester, amide, ...), and/or or a rigid function (alkene, alkyne, phenyl, ...).

Fig.7 summarises some examples of high optical anisotropy liquid crystals that can be used in LCDs according to the present invention. "R" can be composed, independently, by an atom (F, Cl, Br, I, H, ...), a functional group (NH₂, NO₂, CN, SO₃H, COOH, ...) or their salts, or an aliphatic, or oligoether moieties, or a combination of them, preceded by an heteroatom (S, O, N, ...), and/or a semi-flexible function (ester, amide, ...), and/or or a rigid function (alkene, alkyne, phenyl, ...).

Fig.8 represents the device structure of example 1.

Fig.9 represents one of the discotic structure XXX, soluble in high polarity solvents, that can be used in the present invention.

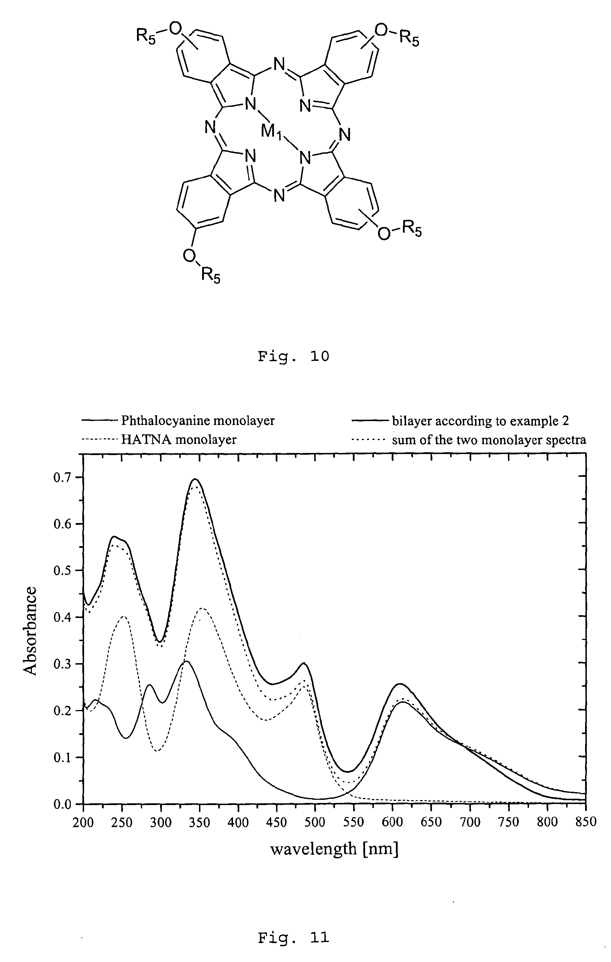

Fig.10 represents one of the discotic structure XXXI, insoluble in high polarity solvents, that can be used in the present invention.

Fig.11 shows the comparison between the solid-state absorption spectra of an hexa-aza-trinaphthylene XXX soluble in acetone, and an acetone insoluble phthalocyanine derivative XXXI; and of the bilayer device obtained by spin coating according to the present invention.

### Detailed description of the invention

The present invention relates to a method for the manufacturing of multilayer mesogenic materials by use of solubility complementarities between the organic mesogenes to be deposited.

On a substrate 1, coated by one to four alignment and/or electrode layers 2, is deposited a first solution with a first mesogenic material m₁ dissolved in a first solvent S₁, forming a first layer of mesogenic material 3. A second layer is then added on the top of the first mesogenic material 3, from a solution consisting in a second material m₂ dissolved in a second solvent, this second solvent should not be able to solubilise the first material m₁ to avoid the deterioration and/or the washing of the material m₁ by said second solvent. This process leads to the formation of the second layer of mesogenic material 4 and can be continued until the right number of layers is achieved.

According to the present invention, the last deposited layer should always be insoluble in the solvent of the next layer to be deposited.

The top layer 5 is then added. This layer comprises one to four alignment and/or electrode layers.

The substrate 1 consists in a flat hard or flexible surface. Non-restrictive examples of such materials are glass, quartz, silica, silicon, mica, organic polymers [polyethylene (PE), polypropylene (PP), polybutadiene (PBD), polystyrene (PS), polyvinylchloride (PVC), polyurethanes (PU), polyethyleneterephthalate (PET), polymethacrylates (Plexiglas, ...), blends or copolymers of them, chemically and/or physically modified or not. These substrates are well known by those skilled in the art.

The substrate 1 can be optionally coated with one to four electrode/alignment layers 2 with a thickness of 0.1 to 100 nm each. These layers align the material m₁ of the first layer of mesogens 3 in a certain direction and/or act simply as an electrode.

Typical materials for electrode layers 2 or 5 are metals like gold, silver, aluminium, magnesium, ...etc and/or metal oxides like tin oxide, indium tin oxide, zinc oxide, indium zinc oxide, titanium oxide, gallium oxide, yttrium oxide, terbium oxide, praseodymium oxide, ... etc. Inorganic salts like lithium fluoride (LiF), cesium fluoride (CsF), lithium oxide (Li₂O), ... are also possible candidates. Organic materials such as conjugated polymers are furthermore possible candidates. Non limitative examples are, PEDOR (poly[3,4-(ethylene-1,2-dioxy)thiophene]), PEDOT-PSS, polyaniline, polypyrrole, polythiophene, polytetrafluoroethylene (PTFE), substituted or not, cross-liked or not. These substrates are well known by those skilled in the art.

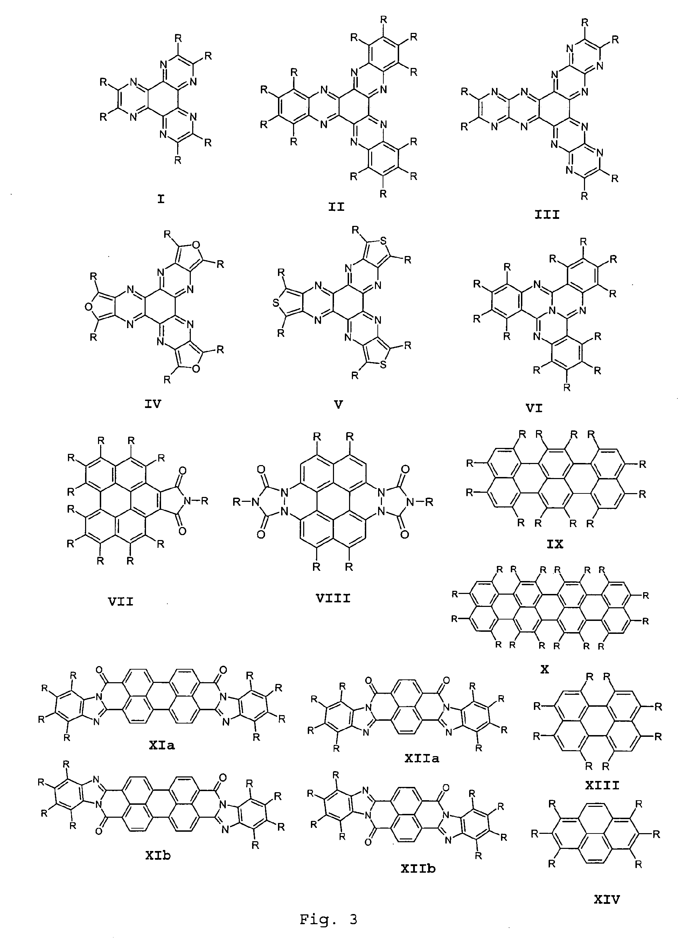

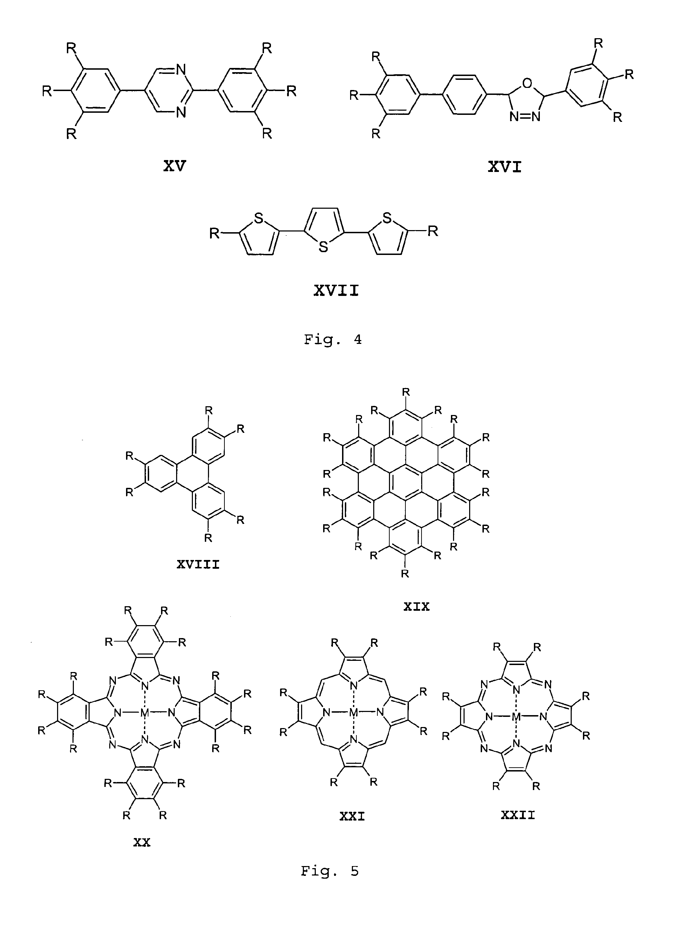

In electronic components, the nature of the first mesogenic material m₁ will be conditioned by the layers 2. If the work-function of the electrode 2 is low, the first mesogenic material m₁ has to be a n-type semiconductor. Examples of such n-type semi-conductors are represented in Fig.3 and 4 and can be discotic liquid crystal derived from the hexaazatriphenylene I, hexaazatrinaphthylene II, dodecaazatrinaphthylene III, hexaazatriisooxanaphthene IV, hexaazatriisothianaphthene V, tricycloquinazoline VI, perylo[1,12-efg]isoindole-1,3-dione VII, tetraazatetrahydrocoronene-tetracarboxylic acid bisphenylimide VIII, terylene IX, quaterylene X, perylene bisamidine XIa XIb, perinone bisbenzimidazole XIIa XIIb, perylene XIII, pyrene XIV, ... aromatic cores, substituted with flexible side-chains; or calamitic liquid crystal derived from the 2,5-Diphenyl-pyrimidine XV, 2-Biphenyl-4-yl-5-phenyl-2,5-dihydro-[1,3,4]oxadiazole XVI, terthiophene XVII, ... substituted with flexible side-chains.

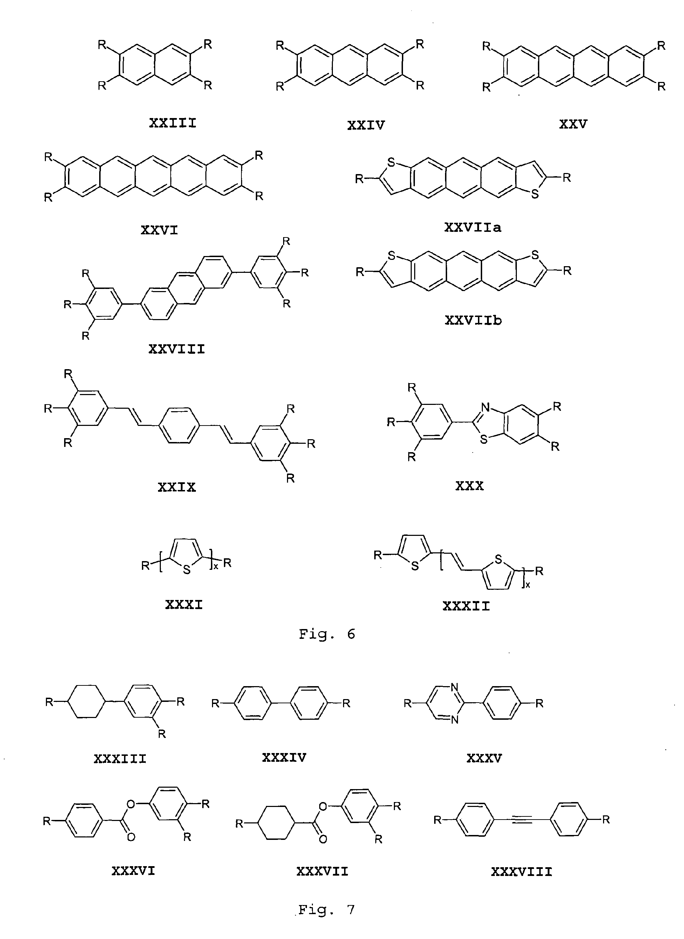

If the work-function of the electrode 2 is high, the first mesogenic material m₁ has to be a p-type semiconductor. Examples of such p-type semiconductors are represented in Fig. 5 and 6 and can be a discotic liquid crystal derived from the triphenylene XVIII, hexabenzocoronene XIX, phthalocyanine XX, porphyrin XXI, tetraazaporphyrin XXII, ... aromatic cores, substituted with flexible side-chains; or it can be a calamitic liquid crystal derived from naphthalene XXIII, anthracene XXIV, tetracene XXV, pentacene XXVI, Dithiadicyclopenta[b,i]anthracene XXVIIa XXVIIb, 2,6-Diphenylanthracene XXVIII, 1,4-Distyryl-benzene XXIX, 2-Phenylbenzothiazole XXX, oligothiophene XXXI, oligovinylthiophene XXXII, ...

The solvents S₁ to Sⱼ used to dissolve the first mesogenic material highly depends on the solubility characteristics of the first material. Representative solvents include, but are not intended to be limited to, aromatic and aliphatic hydrocarbons, haloaromatic and haloaliphatic hydrocarbons, water, ether, ester, keton, alcohol, amine, amide, or acid based solvents. Particularly preferred solvents are toluene, xylenes, chloroform, dichloromethane, hexane, water, methanol, ethanol, isopropanol, diethylether, acetone and acetic acid.

Preferred methods for the depositing of the first mesogenic material m₁ is solution based coating such as spin coating, doctor blading, Langmuir-Blodgett, zone-casting, or any variant of those. A particularly preferred method is the spin coating technique. The films are obtained by injecting the solution on the spinning substrate at 500 to 5000 rpm, with or without gradient of speed or acceleration. Spinning time can be from 2 to 300 seconds. The injection can be performed before or during spinning. The solution and the substrate 1 can be independently heated up or cooled down at a temperature of -70°C to 250°C. The coating can be performed under air, argon, nitrogen, ... or in the presence of a solvent vapour. The thin film obtained can have from 1 nm to 2 µm of average thickness. The solvent of the mesogenic material m₁ evaporates during the spinning operation.

The nature of the second mesogenic material m₂ will depend on the nature of the layer 3. In the case of PVCs, the layer 4 has to be complementary with the layer 3. If the material used in 3 is of n-type, the material of 4 has to show an electron donor character (p-type), and vice versa. Some examples of both families of semiconductors are given above. In the case of OLEDs, the layer 4 will act as an electroluminescent layer. The material has to be both electrons and holes acceptor to be luminescent. Such a material can derive from the terylene IX, quaterylene X, perylene XIII, pyrene XIV, ... aromatic cores, substituted with flexible side-chains.

For certain applications (OLEDs, LCDs, ...), additional layers of mesogenic materials are requested. The materials composing the complementary layers have to be chosen according to the needs. According to the invention, those supplementary layers have to be deposited with a solvent that cannot dissolve the material composing the previous layer.

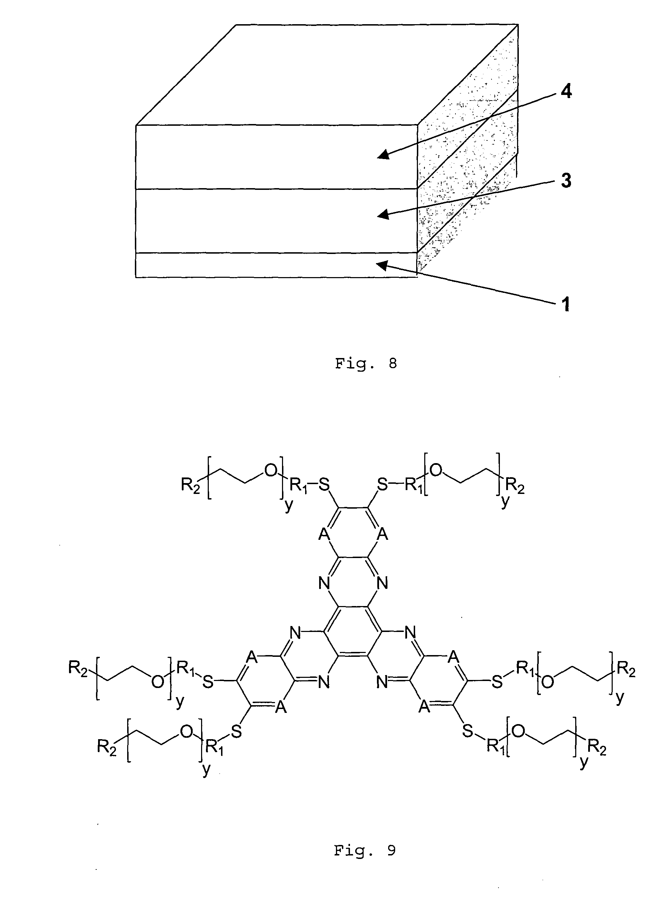

In the case of some LCDs, mesogenic materials with high optical anisotropy are needed. Some examples of materials are given in Figure 7.

When the desired mesogenic multilayer structure is achieved the electronic component/device can be optionally encapsulated.

### Detailed description of preferred combinations of the invention

The preferred embodiments are disclosed by the following particularly contemplated combinations.
1. bilayer device comprising two layers of calamitic or discotic materials m₁ and m₂. Only one of both materials is soluble in hexane. The multilayer structure is achieved by spin coating the two layers on top of each other;
2. bilayer device comprising two layers of calamitic or discotic materials m₁ and m₂. Only one of both materials is soluble in water. The multilayer structure is achieved by spin coating the two layers on top of each other;
3. bilayer device comprising a first layer of calamitic material soluble in acetone and insoluble in toluene, and a second layer of discotic material soluble in toluene. The multilayer structure is achieved by spin coating the two layers on top of each other;
4. four-layers device comprising two layers of calamitic materials and two layers of discotic materials is made by a combining the processes of spin coating and Doctor-blading;
5. bilayer device comprising two layers of discotic materials that are crystalline at device working temperature. The multilayer structure is achieved by spin coating the two layers on top of each other.

Proceeding from an 5, 6, 11, 12, 17, 18-hexaazatrinaphthylene (HATNA) or 1, 4, 5, 6, 7, 10, 11, 12, 13, 16, 17, 18-dodecaaza-trinaphthylene (DATNA) derivative of the structure XXXIX, soluble in high polarity solvents such as water, methanol, ethanol, acetone, toluene or chloroform; and a room temperature liquid crystalline tetrasubstituted phthalocyanine derivative of the structure XL, which is insoluble in said high polarity solvents.

In one of the preferred embodiments of the invention, poly-aza-trinaphthylene derivatives of the structure XXXIX are defined as follows: 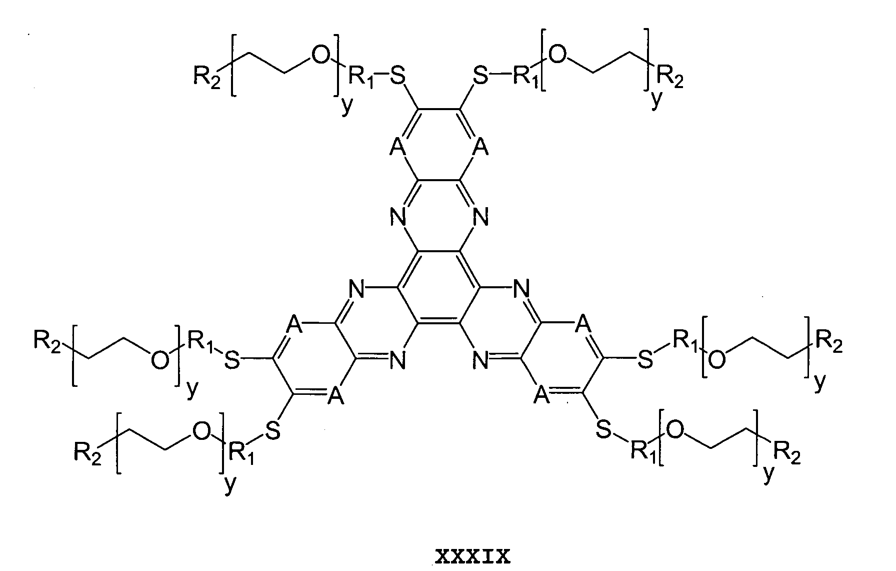 wherein A is C-R₄ or N (nitrogen), and y is the number of ethyleneoxy units in each chain.
R₂ is
   hydrogen (H) or deuterium (D)
   halogen (F, Cl, Br or I)
   nitro (NO₂)
   nitryl (CN)
R₄ is
   ether (O-R₃)
   ester (O-CO- R₃ or CO-O- R₃)
   ketone (CO-R₃)
   alkyl (R₃)
with R₁ and R₃ being an alkyl group, branched or not, of 1 to 10 carbon atoms. The number of ethyleneoxy units y is fixed between 1 and 6.

In another preferred embodiment of the invention, tetrasubstituted phthalocyanine derivatives of the structure XL are defined as follows: 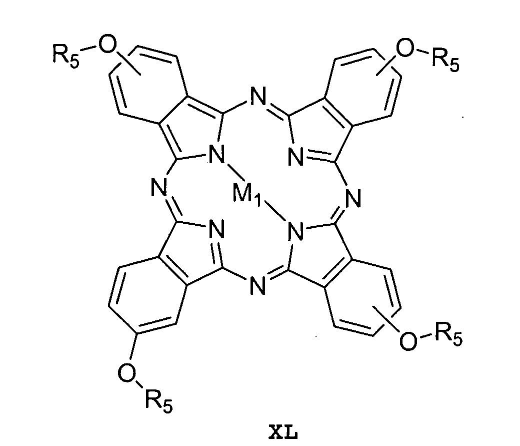 wherein M₁ is a metal (zinc (Zn), copper (Cu), platinum (Pt), palladium (Pd)) or two protons (H₂), and R₅ is a branched aliphatic chain of 8 to 24 carbon atoms.

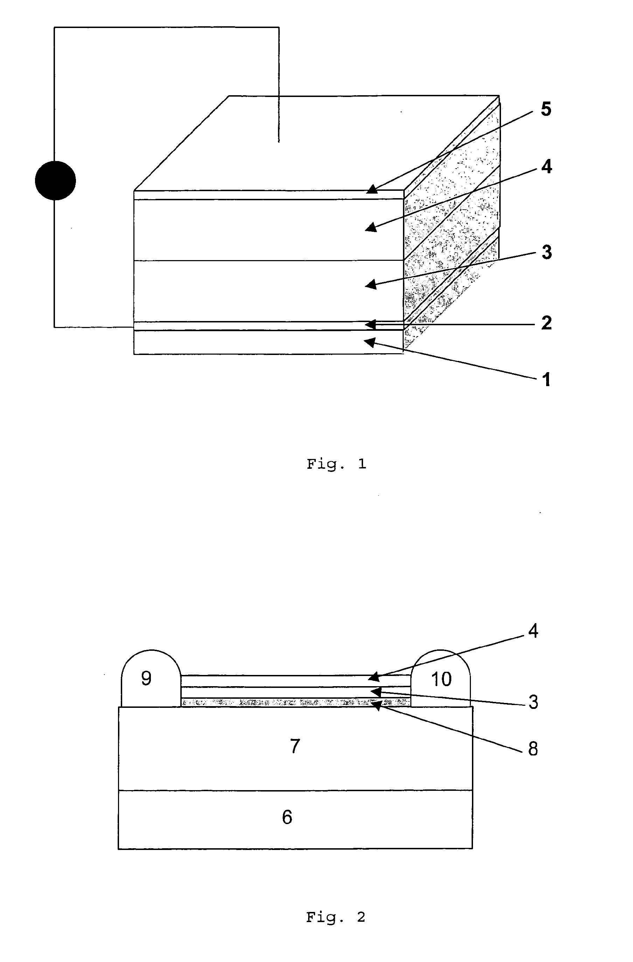

In the general embodiment, illustrated in Fig. 1, spin coating is used for the film deposition.

### General operating mode of the present invention

A solution of 0.1 to 50 gram per litre of the phthalocyanine derivative XL is made. The solvent is dichloromethane, chloroform, toluene, xylene, or hexane. In order to increase the solution concentration, the later can be heated up to reflux. The solution (hot or cold) is spin coated on a substrate 1 consisting in a flat surface as defined above, coated with 50 nm of indium tin oxide (ITO) that acts as low work function electrode 2. The film thickness, regularity, and roughness is regulated by the general spinning conditions, the concentration of the solution and the nature of the solvent.

The spinning rate is generally chosen between 500 and 5000 rpm with or without gradient of speed or acceleration, and the spinning time is chosen between 2 and 300 seconds. Under these conditions, a good quality film 3 can be obtained, with a thickness range of 5 to 500 nm.

A solution of 0.1 to 50 gram per litre of an hexaaza-trinaphthylene derivative XXXIX is made. In order to increase the solution concentration, the later can be heated up until reflux. The solution (hot or cold) is spin coated on the top of the film 3, using a spinning rate of 500 to 5000 rpm with or without gradient of speed or acceleration, and a spinning time of 2 to 300 seconds. Under these conditions, a good quality film 4 can be obtained on the top of 3, with a thickness range of 5 to 500 nm. The top layer 5, preferably consisting in a metallic (calcium, silver, aluminium, ...) and/or inorganic salts (LiF, CsF, Li₂O, ...) and/or organic (PEDOT-PSS, ...) electrode and/or in an aligning layer (PTFE, ...) is then coated.

### Example 1:

### Bilayer component manufacturing, of two discotic mesogenes by spin coating

Two solutions of low molecular weight semiconductors are made, using two different solvents. In the former, 15 mg of 2, 9 (10), 16 (17), 23 (24)-Tetra(2-decyltetradecyloxy)-phthalocyanine (M₁ is H₂ ; R₅ is 2-decyltetradecyl) is dissolved in 1 mL of chloroform. The later is obtained by dissolving 20 mg of 2, 3, 8, 9, 14, 15-hexa{2-[2-(2-methoxy-ethoxy)-ethoxy]-5, 6, 11, 12, 17, 18-hexaazatrinaphthylene (A is C-R₄ ; R₄ is H ; R₁ is C₂H₄ ; R₂ is O-CH₃ ; y is 2) in 1 mL of acetone.
A first layer of organic semiconductor is spin-coated on a quartz substrate (rotation speed: 1500 rpm; spinning time: 30 sec.). The second layer is then coated (rotation speed: 1500 rpm; spinning time: 30 sec.) on its top, forming two layers of small molecules semiconductors. The presence of the two materials in the final multilayer coating is proven by taking an UV-visible absorption spectrum. Fig. 11 shows the absorption spectrum of the bilayer device, in comparison with the pure materials solid-state spectra and their arithmetic sum.

Legend
1. substrate
2. first electrode layer (one to four layers of metal and/or metal oxide and/or organic material)
3. first layer of mesogenic material m₁
4. second layer of mesogenic material m₂
5. second electrode layer (one to four layers of metal and/or metal oxide and/or organic material)
6. gate electrode
7. insulating layer
8. alignment layers (optional)
9. drain electrode
10. source electrode

## Claims

1. Method for the manufacturing of an electronic component comprising the deposition of a multilayer structure of the successive mesogenic materials m₁, m₂.., mⱼ on a substrate (1) comprising the steps of:
- dissolving of a mesogenic material m₁,m₂..,mⱼ respectively in the solvents S₁, S₂.. Sⱼ ;
- depositing a first layer of said first mesogenic material m₁ dissolved in S₁, on a substrate (1);
- depositing a second layer of said second mesogenic material m₂ dissolved in S₂, on said first layer of mesogenic material m₁;
- depositing finally a supplementary layer of the mesogenic material mⱼ dissolved in Sⱼ, on a layer of mesogenic material m₍ⱼ₋₁₎;
wherein the mesogenic material m ₍ᵢ₋₁₎ is insoluble in the solvent Sᵢ of the following mesogenic material mᵢ in the manufacturing of the successive layers m₁, m₂.., mⱼ to avoid the washing of the layer m ₍ᵢ₋₁₎ by the solvent Sᵢ. (i = 2 to j)

2. The method of Claim 1 wherein the mesogenic materials m₁, m₂.., mⱼ are selected from the group consisting of calamitic and/or discotic materials.

3. The method of Claim 1 wherein said mesogenic materials m₁, m₂.., mⱼ are in a crystalline phase or in a mesophase and in particular in a plastic crystalline phase, liquid crystalline phase or glass phase at processing or electronic device working temperatures.

4. The method of Claim 1 wherein the solvents S₁, S₂.. Sⱼ are selected from the group consisting of aromatic and aliphatic hydrocarbons, haloaromatic and haloaliphatic hydrocarbons, water, ether, ester, keton, alcohol, amine, amide, and acid based solvents.

5. The method of Claim 2 wherein the discotic n-type materials are selected from the group consisting of the structures I to XIV:

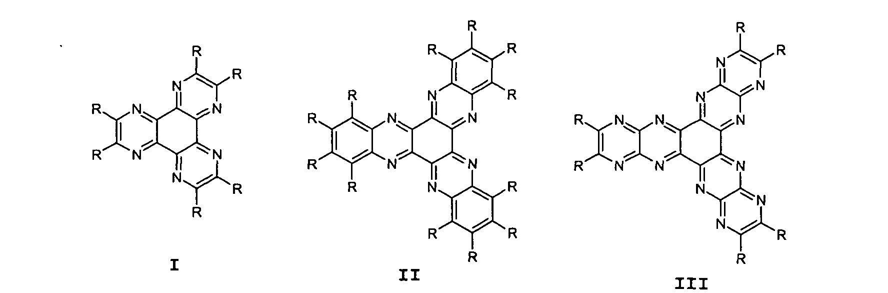

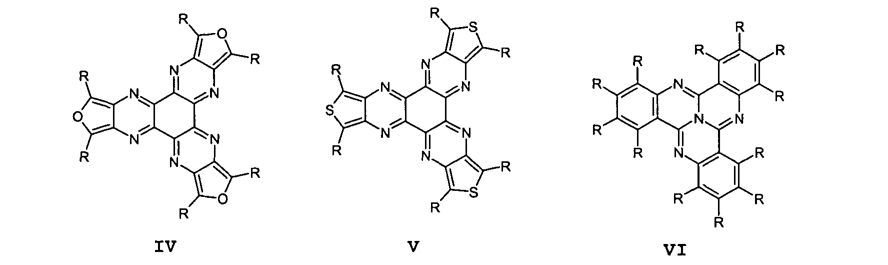

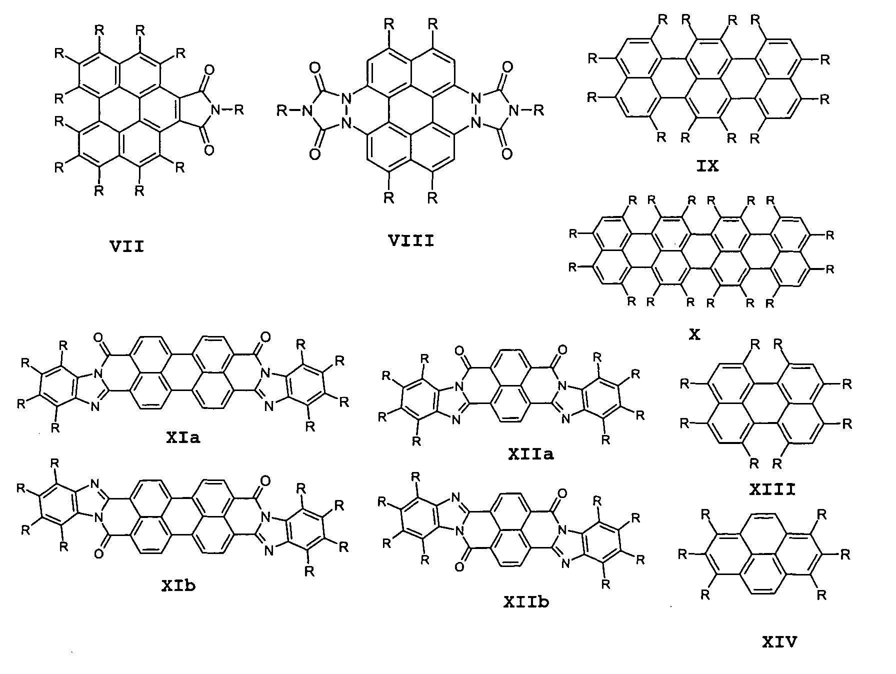

6. The method of Claim 2 wherein the calamitic n-type materials are selected from the group consisting of the structures XV to XVII:

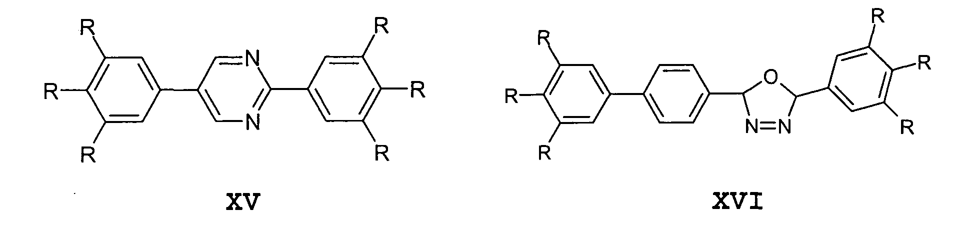

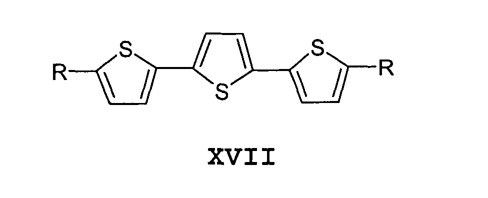

7. The method of Claim 2 wherein the discotic p-type materials are selected from the group consisting of the structures XVIII to XXII:

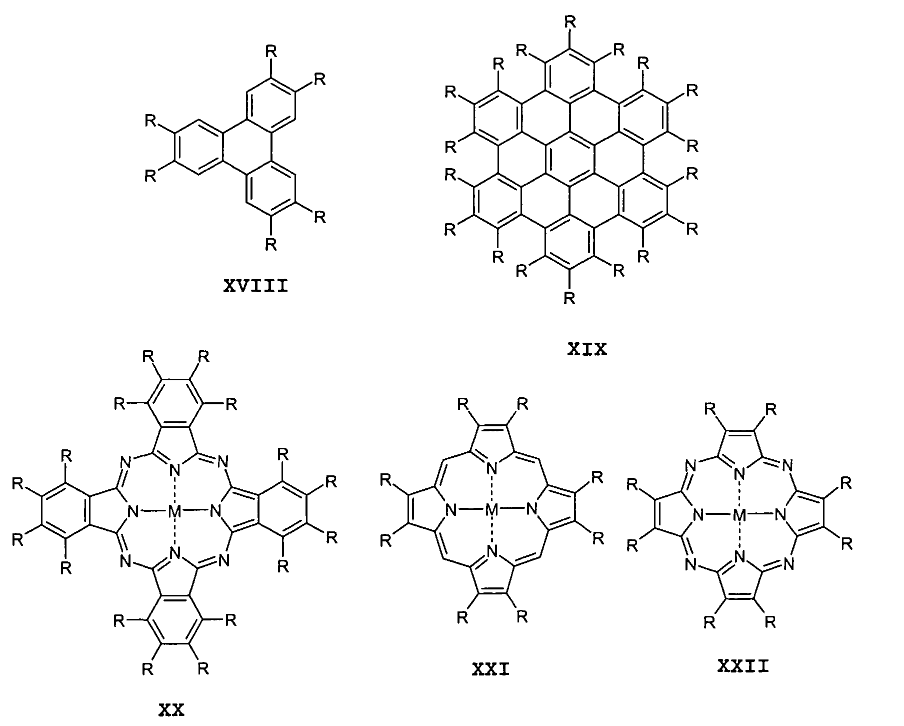

8. The method of Claim 2 wherein the calamitic p-type materials are selected from the group consisting of the structures XXIII to XXXII:

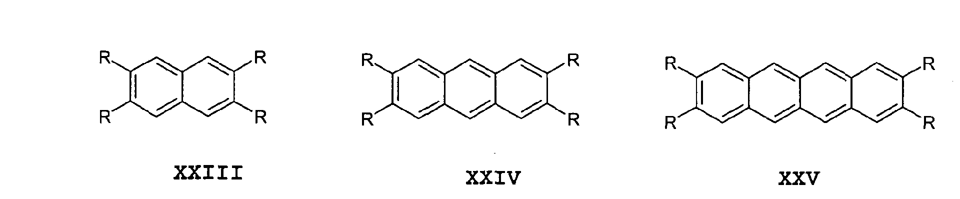

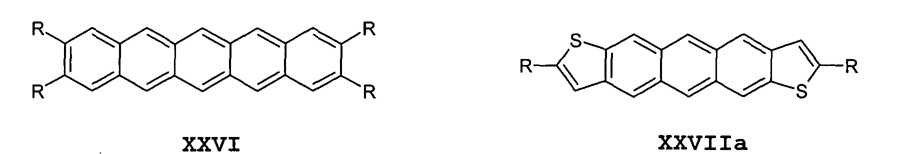

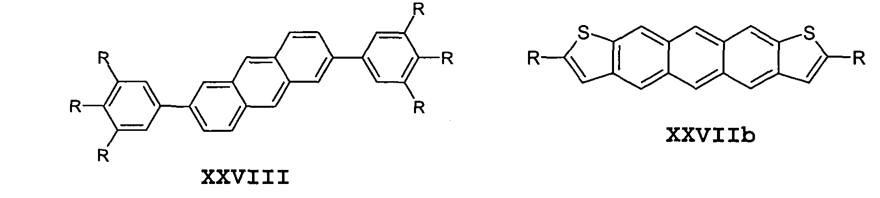

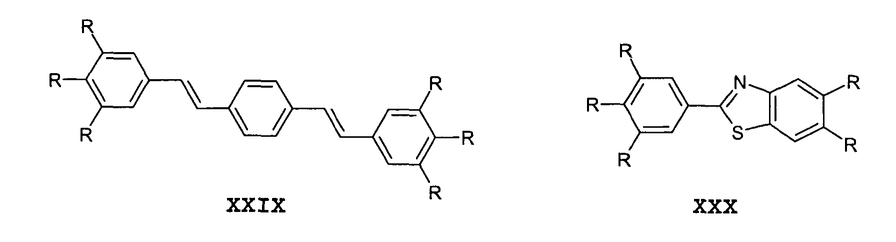

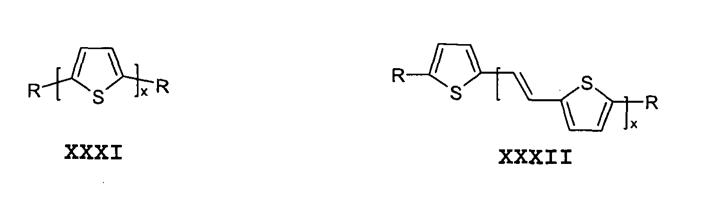

9. The method of Claim 2 wherein high optical anisotropy liquid mesogenic materials are selected from the group consisting of the structures XXXIII to XXXVIII:

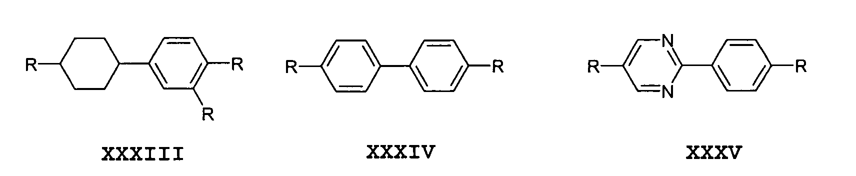

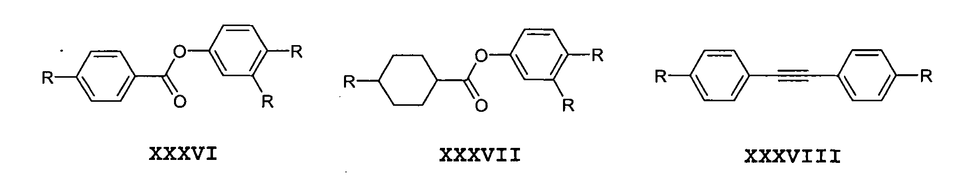

10. The method according to any of the preceding claims wherein a discotic material, soluble in high polarity solvents, is the structure XXXIX:

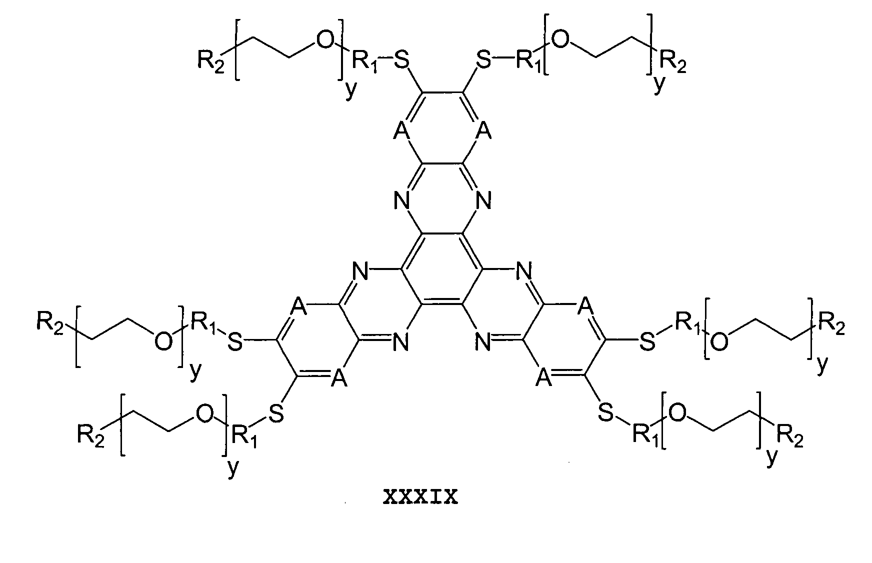

11. The method according to any of the preceding claims wherein a discotic material insoluble in high polarity solvents is the structure XL:

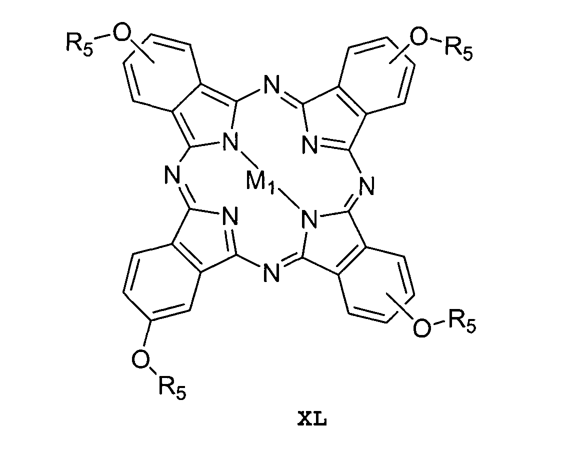

12. The method according to any of the preceding claims
- wherein "x" is the number of thiophene or vinylthiophene units and is between 2 and 6.
- wherein "M" can be one metal atom (Cu, Zn, Co, Pt, ...) or two atoms (Li₂, H₂).
- wherein "R" is an atom such as F, Cl, Br, I, H, ..., a functional group such as NH₂, NO₂, CN, SO₃H, COOH, ... or their salts, an aliphatic, an oligoether moieties, or a combination of them, preceded by a heteroatom such as S, O, N, ..., and/or a semi-flexible function such as ester, amide, ..., and/or or a rigid function such as alkene, alkyne, phenyl,....
- wherein "A" is C-R₄ or N (nitrogen), and y is the number of ethyleneoxy units in each chain.
R₂ is
hydrogen (H) or deuterium (D)
halogen (F, Cl, Br or I)
nitro (NO₂)
nitryl (CN)
R₄ is
ether (O-R₃)
ester (O-CO- R₃ or CO-O- R₃)
ketone (CO-R₃)
alkyl (R₃)
with R₁ and R₃ being an alkyl group, branched or not, of 1 to 10 carbon atoms. The number of ethyleneoxy units y is fixed between 1 and 6.
- wherein M₁ is a metal (zinc (Zn), copper (Cu), platinum (Pt), palladium (Pd)) or two protons (H₂), and R₅ is a branched aliphatic chain of 8 to 24 carbon atoms.

13. The method according to any of the preceding claims wherein a discotic material insoluble in high polarity solvents is: 2, 9 (10), 16 (17), 23 (24)-Tetra(2-decyltetradecyloxy)-phthalocyanine XL (M₁ is H₂ ; R₅ is 2-decyltetradecyl).

14. The method according to any of the preceding claims wherein a discotic material soluble in high polarity solvents is: 2, 3, 8, 9, 14, 15-hexa{2-[2-(2-methoxy-ethoxy)-ethoxy]-5, 6, 11, 12, 17, 18-hexaazatrinaphthylene XXXIX (A is C-R₄ ; R₄ is H ; R₁ is C₂H₄ ; R₂ is O-CH₃ ; y is 2)

15. The method according to any of the preceding claims wherein the deposited successive layers have a thickness from 1 nm to 2 µm each.

16. The method of any of the preceding claims wherein said layers are deposited by spin coating, doctor blading, zone casting, or the Langmuir-Blodgett technique.
